# EUROPÄISCHE PATENTSCHRIFT

(11) **EP 0 518 047 B1**
(45) Veröffentlichungstag und Bekanntmachung des Hinweises auf die Patenterteilung: **11.10.1995**
(21) Anmeldenummer: 92107562.8
(22) Anmeldetag: 05.05.1992
(51) Int. Cl.: H01R 4/68, H01B 12/00, H01L 39/24

(54) **Mit metallischen Leitern kontaktierte massive keramische Supraleiter sowie Herstellungsverfahren**
Bulky ceramic superconductors bonded to metallic conductors and method for their production
Supraconducteurs céramiques massifs en contact avec des conducteurs métalliques ainsi que procédé de fabrication

(30) Priorität: 08.06.1991 DE 4118988
(43) Veröffentlichungstag der Anmeldung: 16.12.1992
(73) Patentinhaber: HOECHST AKTIENGESELLSCHAFT, 65926 Frankfurt am Main (DE)
(72) Erfinder: Bock, Joachim, Dr., W-5042 Erftstadt (DE); Preisler, Eberhard, Dr., W-5042 Erftstadt (DE); Elschner, Steffen, Dr., W-6272 Niedernhausen (DE)

(56) Entgegenhaltungen:
- EP-A- 0 404 966
- DE-A- 3 830 092

## Beschreibung

Die vorliegende Erfindung betrifft mit metallischen Leitern kontaktierte Massivkörper aus Hochtemperatur-Supraleiter-Material sowie Verfahren zu ihrer Herstellung.

Aus der US-PS 5 047 391 ist bekannt, Formkörper aus Hochtemperatur-SupraleiterMaterial dadurch herzustellen, daß man aus den Oxiden des Bismuts, Strontiums, Calciums und Kupfers in einem Molverhältnis der Metalle von 2 : 2 : 1 : 2 im Temperaturbereich von 870 bis 1100 °C eine homogene Schmelze herstellt, in Kokillen vergießt und darin erstarren läßt. Die aus den Kokillen entnommenen Gußkörper tempert man zunächst bei Temperaturen von 780 bis 850 °C und behandelt sie schließlich in Sauerstoffatmosphäre bei Temperaturen von 600 bis 830 °C.

Beim Verfahren zur Kontaktierung von Hochtemperatur-Supraleitern auf der Basis von - Yttrium, Bismut und Thallium nach der US-PS 4 963 523 wird in einem ersten Schritt die Oberfläche des Hochtemperatur-Supraleiter-Materials unter Luftabschluß durch Ätzen gut gesäubert und in einem zweiten Schritt ein metallischer Kontakt aus Edelmetallen oder ihren Legierungen direkt auf das Hochtemperatur-Supraleiter-Material aufgebracht.

Aus der EP-A-0 404 966 ist ein Verfahren zur Herstellung eines supraleitenden Drahtes aus keramischem Material bekannt, bei dem ein über ein Schmelzprozeß gewonnenes Pulver der Zusammensetzung Bi₂Sr₂CaCu₂Oₓ in Röhrchen aus Silber oder Silberlegierungen eingefüllt wird, und dann das Röhrchen durch mechanische Bearbeitung in ein schmales Band verformt wird. Das Band weist beispielsweise eine Breite von 5 mm und eine Dicke von 2 mm auf. Anschließend wird das Band bei Temperaturen wenig unterhalb des Schmelzpunktes des Silbers geglüht. Das resultierende Material weist eine kritische Stromdichte jc von mindestens 30 000 A/cm² auf.

Es ist auch üblich, auf Hochtemperatur-Supraleiter-Material Suspensionen von Edelmetallen in Form eines Lackes oder einer Paste aufzubringen, wobei nach Verdampfen des Lösungsmittels auf der Oberfläche des Hochtemperatur-Supraleiter-Materials ein feiner Metallfilm verbleibt, auf dem Lötkontakte angebracht werden können.

Nachteilig ist bei den nach den bekannten Verfahren erhaltenen Kontakten deren geringe mechanische Stabilität. Darüber hinaus ist nach Aufbringen des Edelmetalles zum Erhalt eines guten elektrischen Kontaktes in der Regel eine Wärmebehandlung erforderlich, wodurch die supraleitenden Eigenschaften des Materials negativ beeinträchtigt werden können.

Es ist daher Aufgabe der vorliegenden Erfindung, mit metallischen Leitern kontaktierte Massivkörper aus Hochtemperatur-Supraleiter-Material bereitzustellen sowie Verfahren zu ihrer Herstellung anzugeben, bei welchen die entstehende Kontaktstelle bei guter mechanischer Stabilität einen sehr niedrigen elektrischen Widerstand, beispielsweise im Bereich von Mikro-Ohm, aufweist.

Gegenstand der Erfindung sind daher Massivkörper, bestehend aus Hochtemperatur-Supraleiter-Material, welches aus den Oxiden des Bismuts, Strontiums, Calciums und Kupfers sowie gegebenenfalls des Antimons und Bleis erhältlich ist und aus kompakten metallischen Leitern aus Silber, Gold, einem Platinmetall oder einer diese Metalle enthaltenden Legierung, wobei die kompakten metallischen Leiter mit nur kurzer Länge in das Hochtemperatur-Supraleiter-Material eintauchen.

Gegenstand der Erfindung ist auch ein Verfahren zur Herstellung solcher Massivkörper, welches dadurch gekennzeichnet ist, daß man das Hochtemperatur-Supraleiter-Material vollständig aufschmilzt, daß man die festen kompakten Leiter mit der Schmelze partiell umhüllt, daß man die Schmelze erstarren läßt und daß man den erhaltenen Massivkörper zusammen mit den Leitern in einer ersten Stufe bei Temperaturen von 710 bis 810 °C und in einer zweiten Stufe in sauerstoffhaltiger Atmosphäre bei Temperaturen von 750 bis 880 °C glüht.

Das Verfahren gemäß der Erfindung kann weiterhin wahlweise auch noch dadurch ausgestaltet sein, daß
a) man das vollständige Aufschmelzen des Hochtemperatur-Supraleiter-Materials durch Erhitzen auf Temperaturen bis zu 1100 °C erreicht;
b) man das Hochtemperatur-Supraleiter-Material auf Temperaturen von 950 bis 1000 °C erhitzt;
c) man die Glühung in der ersten Stufe in Inertgasatmosphäre durchführt;
d) man die Glühung in der ersten Stufe in Luft durchführt;
e) man die erste Stufe der Glühung 0,5 bis 60 Stunden lang vornimmt;
f) man die Glühung in der zweiten Stufe in einer Atmosphäre aus reinem Sauerstoff durchführt;
g) man die Glühung in der zweiten Stufe in Luft durchführt;
h) man die Glühung in der zweiten Stufe in einer Sauerstoff und Inertgas enthaltenden Atmosphäre durchführt;
i) man die zweite Stufe der Glühung 6 bis 100 Stunden lang vornimmt.

Beim erfindungsgemäßen Massivkörper aus Hochtemperatur-Supraleiter-Material, welcher mit festen kompakten metallischen Leitern kontaktiert ist, sind die Übergangswiderstände an der Kontaktierungsstelle dann besonders niederohmig, wenn die metallischen Leiter weder durch Luftsauerstoff noch durch das schmelzflüssige Hochtemperatur-Supraleiter-Material oxidiert werden. Das ist beispielsweise bei Silber, Gold und den Platinmetallen der Fall.

Weiterhin ist es beim Massivkörper gemäß der Erfindung zur Erzielung eines niedrigen Übergangswiderstandes von Vorteil, wenn die metallischen Leiter in das Hochtemperatur-Supraleiter-Material nur mit kurzer Länge eintauchen, während sie einen großen Querschnitt wegen einer beträchtlichen Kontaktfläche im Hochtemperatur-Supraleiter-Material aufweisen.

Beim erfindungsgemäßen Verfahren kann die Glühung in der ersten Stufe auch in einer Mischung aus Inertgas und Luft durchgeführt werden.

Beim Verfahren gemäß der Erfindung werden die beiden Glühstufen bei Temperaturen durchgeführt, die deutlich unterhalb der Schmelzpunkte der jeweils verwendeten Edelmetalle liegen.

Die beim erfindungsgemäßen Verfahren während der Glühungen im Massivkörper auftretende partielle Schmelze bewirkt den innigen Kontakt zwischen dem Hochtemperatur-Supraleiter-Material und dem metallischen Leiter.

Beim Verfahren gemäß der Erfindung wird die Überführung der erstarrten Schmelze in den supraleitenden Zustand und die Ausbildung des guten elektrischen Kontaktes durch die beiden Glühstufen erreicht, die in einem Wärmebehandlungszyklus erfolgen können.

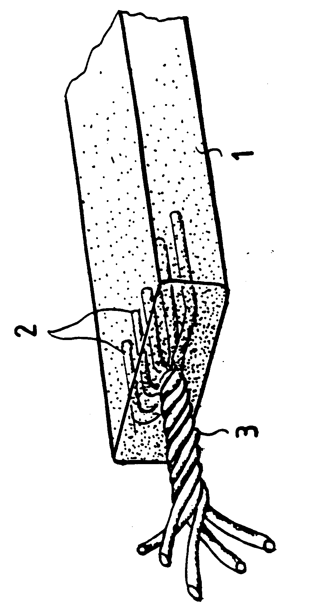

In der beigefügten Zeichnung ist beispielhaft eine Hälfte eines nach dem erfindungsgemäßen Verfahren kontaktierten Massivkörpers schematisch dargestellt.

In einem aus erstarrter Schmelze aus Hochtemperatur-Supraleiter-Material bestehenden Massivkörper 1 sind mittig in einer Ebene und mit Abstand voneinander fünf Silberdrähte 2 angeordnet. Die Silberdrähte 2 bilden außerhalb des Massivkörpers 1 einen Verdrillungsbereich 3.

### Beispiel 1 (Vergleichsbeispiel)

In eine oben offene, rechteckige Kupferform (Abmessungen: 15 x 15 x 60 mm³) wurden durch kleine Bohrungen in ihren Stirnflächen je ein etwa 50 mm langes Silberrohr (Außendurchmesser: 1,6 mm) derartig eingeschoben, daß auf jeder Seite etwa 30 mm Silberrohr herausragte. Dann wurde in die Kupferform eine homogene Schmelze binärer Oxide von Bismut, Strontium, Calcium und Kupfer vergossen, wobei das Molverhältnis der Metalle zueinander 2 : 2 : 1 : 2 betrug.

Die Silberrohre waren mit der erstarrten Schmelze mechanisch fest verbunden. Weiterhin zeigte ein Querschliff der erstarrten Schmelze mit dem darin befindlichen Silberrohr, daß das Rohr vollkommen glattrandig und vollständig von erstarrter Schmelze umgeben war, so daß Wechselwirkungen zwischen der Schmelze und dem Silberrohr offensichtlich nicht erfolgt sein konnten.

Da die erstarrte Schmelze noch nicht supraleitend war, wurde sie mit den in ihr befindlichen Silberrohren aus der Kupferform entnommen und in einem Röhrenofen mit 300°C/h auf 850°C aufgeheizt und unter Luft 36 Stunden bei dieser Temperatur belassen. Nach dieser Wärmebehandlung war die mechanische Verbindung zwischen den Silberrohren und der erstarrten Schmelze aufgehoben, die Silberrohre konnten aus der erstarrten Schmelze herausgezogen werden. Die erstarrte Schmelze war jedoch supraleitend (Sprungtemperatur: 90 K).

### Beispiel 2 (Vergleichsbeispiel)

Beispiel 1 wurde mit der Änderung wiederholt, daß die erstarrte Schmelze mit den in ihr befindlichen Silberrohren auf 820°C aufgeheizt und unter Luft 40 Stunden bei dieser Temperatur belassen wurde.

Ein Querschliff der erstarrten Schmelze mit dem darin befindlichen Silberrohr zeigte eine geringfügige Berührung zwischen erstarrter Schmelze und Silberrohr. Der Widerstand zwischen Silberrohr und erstarrter Schmelze, die jetzt supraleitend war, wurde bei 77 K zu 1,2 Ω gemessen.

### Beispiel 3 (gemäß der Erfindung)

Beispiel 1 wurde mit der Änderung wiederholt, daß die erstarrte Schmelze mit den in ihr befindlichen Silberrohren unter Luft zunächst 20 Stunden bei 750°C und anschließend 60 Stunden bei 850°C getempert wurde. Danach waren die Silberrohre mit der erstarrten Schmelze, die jetzt supraleitend war, mechanisch fest verbunden.

Ein Querschliff zeigte, daß die äußere Oberfläche der Silberrohre stark zerklüftet und Kristallite der erstarrten Schmelze in die Wandung der Silberrohre hineingewachsen waren. Mit Hilfe einer Elektronenstrahlmikrosonde ließ sich Silber auch in der Grenzzone der erstarrten Schmelze nachweisen.

Der Widerstand über die gesamte Probe, d.h. jeweils gemessen an den Austrittsstellen der Silberrohre aus dem Massivkörper aus Hochtemperatur-Supraleiter-Material, betrug bei 77 K 60 µΩ . Die Oberfläche des im Massivkörper befindlichen Teiles jedes Silberrohres betrug jeweils 1 cm².

### Beispiel 4 (gemäß der Erfindung)

Beispiel 3 wurde mit der Änderung wiederholt, daß beide Silberrohre durch jeweils fünf Silberdrähte (Durchmesser: 0,5 mm, Länge im Massivkörper: 17 mm) ersetzt wurden (vergl. die Figur).

Der Widerstand über die gesamte Probe, d.h. jeweils gemessen an den Austrittsstellen der Silberdrähte aus dem Massivkörper, betrug bei 77 K 45 µΩ .

### Beispiel 5 (gemäß der Erfindung)

Beispiel 4 wurde mit der Änderung wiederholt, daß anstelle der Silberdrähte Golddrähte gleicher Abmessungen verwendet wurden.

Der Widerstand bei 77 K ergab sich zu 18 µΩ.

### Beispiel 6 (gemäß der Erfindung)

Beispiel 4 wurde mit der Änderung wiederholt, daß anstelle der Silberdrähte Platindrähte gleicher Abmessungen verwendet wurden.

Der Widerstand bei 77 K ergab sich zu 29 µΩ.

### Beispiel 7 (gemäß der Erfindung)

Beispiel 3 wurde mit der Änderung wiederholt, daß die Silberrohre durch je ein Silberblech (Abmessungen: 17 x 7,3 x 1 mm³) ersetzt wurden.

Der Widerstand bei 77 K ergab sich zu 45 µΩ.

## Patentansprüche (Patentansprüche für folgende(n) Vertragsstaat(en): AT, BE, CH, DE, FR, GB, GR, IT, LI, LU, NL, SE)

1. Massivkörper, bestehend aus Hochtemperatur-Supraleiter-Material, welches aus den Oxiden des Bismuts, Strontiums, Calciums und Kupfers sowie gegebenenfalls des Antimons und Bleis erhältlich ist und aus kompakten metallischen Leitern aus Silber, Gold, einem Platinmetall oder einer diese Metalle enthaltenden Legierung, wobei die kompakten metallischen Leiter mit nur kurzer Länge in das Hochtemperatur-Supraleiter-Material eintauchen.

2. Verfahren zur Herstellung der Massivkörper nach Anspruch 1, dadurch gekennzeichnet, daß man das Hochtemperatur-Supraleiter-Material vollständig aufschmilzt, daß man die festen kompakten Leiter mit der Schmelze partiell umhüllt, daß man die Schmelze erstarren läßt und daß man den erhaltenen Massivkörper zusammen mit den Leitern in einer ersten Stufe bei Temperaturen von 710 bis 810 °C und in einer zweiten Stufe in sauerstoffhaltiger Atmosphäre bei Temperaturen von 750 bis 880 °C glüht.

3. Verfahren nach Anspruch 2, dadurch gekennzeichnet, daß man das vollständige Aufschmelzen des Hochtemperatur-Supraleiter-Materials durch Erhitzen auf Temperaturen bis zu 1100 °C erreicht.

4. Verfahren nach Anspruch 3, dadurch gekennzeichnet, daß man das Hochtemperatur-Supraleiter-Material auf Temperaturen von 950 bis 1000 °C erhitzt.

5. Verfahren nach mindestens einem der Ansprüche 2 bis 4, dadurch gekennzeichnet, daß man die Glühung in der ersten Stufe in Inertgasatmosphäre durchführt.

6. Verfahren nach mindestens einem der Ansprüche 2 bis 4, dadurch gekennzeichnet, daß man die Glühung in der ersten Stufe in Luft durchführt.

7. Verfahren nach mindestens einem der Ansprüche 2 bis 6, dadurch gekennzeichnet, daß man die erste Stufe der Glühung 0,5 bis 60 Stunden lang vornimmt.

8. Verfahren nach mindestens einem der Ansprüche 2 bis 7, dadurch gekennzeichnet, daß man die Glühung in der zweiten Stufe in einer Atmosphäre aus reinem Sauerstoff durchführt.

9. Verfahren nach mindestens einem der Ansprüche 2 bis 7, dadurch gekennzeichnet, daß man die Glühung in der zweiten Stufe in Luft durchführt.

10. Verfahren nach mindestens einem der Ansprüche 2 bis 7, dadurch gekennzeichnet, daß man die Glühung in der zweiten Stufe in einer Sauerstoffund Inertgas enthaltenden Atmosphäre durchführt.

11. Verfahren nach mindestens einem der Ansprüche 2 bis 10, dadurch gekennzeichnet, daß man die zweite Stufe der Glühung 6 bis 100 Stunden lang vornimmt.

## Patentansprüche (Patentansprüche für folgende(n) Vertragsstaat(en): ES)

1. Verfahren zur Herstellung von mit festen kompakten metallischen Leitern kontaktierten Massivkörpern aus Hochtemperatur-Supraleiter-Material, dadurch gekennzeichnet, daß man eine die Oxide des Bismuts, Strontiums, Calciums und Kupfers sowie gegebenenfalls des Antimons und Bleis enthaltende Zusammensetzung vollständig aufschmilzt, daß man die festen kompakten Leiter mit der Schmelze partiell umhüllt, daß man die Schmelze erstarren läßt und daß man den erhaltenen Massivkörper zusammen mit den Leitern in einer ersten Stufe bei Temperaturen von 710 bis 810 °C und in einer zweiten Stufe in sauerstoffhaltiger Atmosphäre bei Temperaturen von 750 bis 880 °C glüht.

2. Verfahren nach Anspruch 1, dadurch gekennzeichnet, daß die Zusammensetzung die Oxide des Bismuts, Strontiums, Calciums und Kupfers im Molverhältnis der Metalle von 2 : 2 : 1 : 2 enthält.

3. Verfahren nach Anspruch 1 oder 2, dadurch gekennzeichnet, daß die festen kompakten metallischen Leiter Silber, Gold, ein Platinmetall oder eine diese Metalle enthaltende Legierung sind.

4. Verfahren nach mindestens einem der Ansprüche 1 bis 3, dadurch gekennzeichnet, daß man das vollständige Aufschmelzen der Zusammensetzung durch Erhitzen auf Temperaturen bis zu 1100°C erreicht.

5. Verfahren nach Anspruch 4, dadurch gekennzeichnet, daß man die Zusammensetzung auf Temperaturen von 950 bis 1000 °C erhitzt.

6. Verfahren nach mindestens einem der Ansprüche 1 bis 5, dadurch gekennzeichnet, daß man die Glühung in der ersten Stufe in Inertgasatmosphäre durchführt.

7. Verfahren nach mindestens einem der Ansprüche 1 bis 5, dadurch gekennzeichnet, daß man die Glühung in der ersten Stufe in Luft durchführt.

8. Verfahren nach mindestens einem der Ansprüche 1 bis 7, dadurch gekennzeichnet, daß man die erste Stufe der Glühung 0,5 bis 60 Stunden lang vornimmt.

9. Verfahren nach mindestens einem der Ansprüche 1 bis 8, dadurch gekennzeichnet, daß man die Glühung in der zweiten Stufe in einer Atmosphäre aus reinem Sauerstoff durchführt.

10. Verfahren nach mindestens einem der Ansprüche 1 bis 8, dadurch gekennzeichnet, daß man die Glühung in der zweiten Stufe in Luft durchführt.

11. Verfahren nach mindestens einem der Ansprüche 1 bis 8, dadurch gekennzeichnet, daß man die Glühung in der zweiten Stufe in einer Sauerstoff und Inertgas enthaltenden Atmosphäre durchführt.

12. Verfahren nach mindestens einem der Ansprüche 1 bis 11, dadurch gekennzeichnet, daß man die zweite Stufe der Glühung 6 bis 100 Stunden lang vornimmt.

## Claims (Claims for the following Contracting State(s): AT, BE, CH, DE, FR, GB, GR, IT, LI, LU, NL, SE)

1. A solid body comprising high-temperature superconducting material which can be obtained from the oxides of bismuth, strontium, calcium and copper and, if optionally, of antimony and lead, and compact metallic conductors composed of silver, gold, a platinum metal or an alloy containing said metals, only a short length of the compact metallic conductors being embedded in the high-temperature superconductor material.

2. A process for producing the solid body as claimed in claim 1, which comprises completely melting the high-temperature superconducting material, partially encasing the solid, compact conductors with the melt, allowing the melt to solidify and annealing the solid body obtained together with the conductors in a first stage at temperatures from 710 to 810°C and in a second stage in an oxygen-containing atmosphere at temperatures from 750 to 880°C.

3. The process as claimed in claim 2, wherein the complete melting of the high-temperature superconducting material is achieved by heating to temperatures of up to 1100°C.

4. The process as claimed in claim 3, wherein the high-temperature superconducting material is heated to temperatures from 950 to 1000°C.

5. The process as claimed in at least one of claims 2 to 4, wherein the annealing in the first stage is carried out in an inert gas atmosphere.

6. The process as claimed in at least one of claims 2 to 4, wherein the annealing in the first stage is carried out in air.

7. The process as claimed in at least one of claims 2 to 6, wherein the first stage of the annealing is carried out for 0.5 to 60 hours.

8. The process as claimed in at least one of claims 2 to 7, wherein the annealing in the second stage is carried out in a pure oxygen atmosphere.

9. The process as claimed in at least one of claims 2 to 7, wherein the annealing in the second stage is carried out in air.

10. The process as claimed in at least one of claims 2 to 7, wherein the annealing in the second stage is carried out in an atmosphere containing oxygen and inert gas.

11. The process as claimed in at least one of claims 2 to 10, wherein the second stage of the annealing is carried out for 6 to 100 hours.

## Claims (Claims for the following Contracting State(s): ES)

1. A process for producing a solid body made of high-temperature superconducting material to which contact is made by solid, compact metallic conductors, which comprises completely melting a composition containing the oxides of bismuth, strontium, calcium and copper and, optionally of antimony and lead, partially encasing the solid, compact conductors with the melt, allowing the melt to solidify and annealing the solid body obtained together with the conductors in a first stage at temperatures from 710 to 810°C and in a second stage in an oxygen-containing atmosphere at temperatures from 750 to 880°C.

2. The process as claimed in claim 1, wherein the composition contains the oxides of bismuth, strontium, calcium and copper in a molar ratio of the metals of 2 : 2 : 1 : 2.

3. The process as claimed in claim 1 or 2, wherein the solid, compact metallic conductors are silver, gold, a platinum metal or an alloy containing said metals.

4. The process as claimed in at least one of claims 1 to 3, wherein the complete melting of the composition is achieved by heating to temperatures of up to 1100°C.

5. The process as claimed in claim 4, wherein the composition is heated to temperatures from 950 to 1000°C.

6. The process as claimed in at least one of claims 1 to 5, wherein the annealing in the first stage is carried out in an inert gas atmosphere.

7. The process as claimed in at least one of claims 1 to 5, wherein the annealing in the first stage is carried out in air.

8. The process as claimed in at least one of claims 1 to 7, wherein the first stage of the annealing is carried out for 0.5 to 60 hours.

9. The process as claimed in at least one of claims 1 to 8, wherein the annealing in the second stage is carried out in a pure oxygen atmosphere.

10. The process as claimed in at least one of claims 1 to 8, wherein the annealing in the second stage is carried out in air.

11. The process as claimed in at least one of claims 1 to 8, wherein the annealing in the second stage is carried out in an atmosphere containing oxygen and inert gas.

12. The process as claimed in at least one of claims 1 to 11, wherein the second stage of the annealing is carried out for 6 to 100 hours.

## Revendications (Revendications pour l'(les) Etat(s) contractant(s) suivant(s): AT, BE, CH, DE, FR, GB, GR, IT, LI, LU, NL, SE)

1. Corps plein consistant en un matériau supraconducteur à haute température, qui peut être obtenu à partir des oxydes de bismuth, de strontium, de calcium et de cuivre, ainsi éventuellement que d'antimoine et de plomb, et de conducteurs métalliques compacts en argent, en or, en un métal du groupe du platine ou en un alliage contenant ces métaux, les conducteurs métalliques compacts ne pénétrant que d'une courte longueur dans le matériau supraconducteur à haute température.

2. Procédé pour la fabrication des corps solides selon la revendication 1, caractérisé en ce que l'on fait fondre complètement le matériau supraconducteur à haute température, en ce que l'on enrobe partiellement les conducteurs compacts solides dans la masse fondue, en ce que l'on fait solidifier la masse fondue et en ce que l'on calcine le corps solide obtenu avec les conducteurs dans une première étape à 710-810°C et dans une seconde étape en atmosphère contenant de l'oxygène à des températures de 750 à 880°C.

3. Procédé selon la revendication 2, caractérisé en ce que l'on atteint la fusion complète du matériau supraconducteur à haute température par chauffage à des températures allant jusqu'à 1 100°C.

4. Procédé selon la revendication 3, caractérisé en ce que l'on chauffe le matériau supraconducteur à haute température à des températures de 950 à 1 000°C.

5. Procédé selon l'une au moins des revendications 2 à 4, caractérisé en ce que l'on effectue la calcination dans la première étape en atmosphère de gaz inerte.

6. Procédé selon l'une au moins des revendications 2 à 4, caractérisé en ce que l'on effectue la calcination dans la première étape dans l'air.

7. Procédé selon l'une au moins des revendications 2 à 6, caractérisé en ce que l'on effectue la première étape de la calcination pendant 0,5 à 60 h.

8. Procédé selon l'une au moins des revendications 2 à 7, caractérisé en ce que l'on effectue la calcination dans la seconde étape dans une atmosphère d'oxygène pur.

9. Procédé selon l'une au moins des revendications 2 à 7, caractérisé en ce que l'on effectue la calcination dans la seconde étape dans l'air.

10. Procédé selon l'une au moins des revendications 2 à 7, caractérisé en ce que l'on effectue la calcination dans la seconde étape dans une atmosphère contenant de l'oxygène et un gaz inerte.

11. Procédé selon l'une au moins des revendications 2 à 10, caractérisé en ce que l'on effectue la seconde étape de la calcination pendant 6 à 100 h.

## Revendications (Revendications pour l'(les) Etat(s) contractant(s) suivant(s): ES)

1. Procédé pour la fabrication de corps pleins en matériau supraconducteur à haute température, munis de conducteurs métalliques compacts solides, caractérisé en ce que l'on fait fondre complètement le matériau supraconducteur à haute température, en ce que l'on enrobe partiellement les conducteurs compacts solides dans la masse fondue, en ce que l'on fait solidifier la masse fondue et en ce que l'on calcine le corps solide obtenu avec les conducteurs dans une première étape à 710-810°C et dans une seconde étape en atmosphère contenant de l'oxygène à des températures de 750 à 880°C.

2. Procédé selon la revendication 1, caractérisé en ce que la composition contient les oxydes de bismuth, de strontium, de calcium et de cuivre dans les proportions molaires des métaux 2:2:1:2.

3. Procédé selon la revendication 1 ou 2, caractérisé en ce que les conducteurs métalliques compacts solides sont en argent, en or, en un métal du groupe du platine ou en un alliage contenant ces métaux.

4. Procédé selon l'une au moins des revendications 1 à 3, caractérisé en ce que l'on atteint la fusion complète du matériau supraconducteur à haute température par chauffage à des températures allant jusqu'à 1 100°C.

5. Procédé selon la revendication 4, caractérisé en ce que l'on chauffe le matériau supraconducteur à haute température à des températures de 950 à 1 000°C.

6. Procédé selon l'une au moins des revendications 1 à 5, caractérisé en ce que l'on effectue la calcination dans la première étape en atmosphère de gaz inerte.

7. Procédé selon l'une au moins des revendications 1 à 5, caractérisé en ce que l'on effectue la calcination dans la première étape dans l'air.

8. Procédé selon l'une au moins des revendications 1 à 7, caractérisé en ce que l'on effectue la première étape de la calcination pendant 0,5 à 60 h.

9. Procédé selon l'une au moins des revendications 1 à 8, caractérisé en ce que l'on effectue la calcination dans la seconde étape dans une atmosphère d'oxygène pur.

10. Procédé selon l'une au moins des revendications 1 à 8, caractérisé en ce que l'on effectue la calcination dans la seconde étape dans l'air.

11. Procédé selon l'une au moins des revendications 1 à 8, caractérisé en ce que l'on effectue la calcination dans la seconde étape dans une atmosphère contenant de l'oxygène et un gaz inerte.

12. Procédé selon l'une au moins des revendications 1 à 11, caractérisé en ce que l'on effectue la seconde étape de la calcination pendant 6 à 100 h.
